# EUROPEAN PATENT SPECIFICATION

(11) **EP 2 869 678 B1**
(45) Date of publication and mention of the grant of the patent: **26.06.2019**
(21) Application number: 13781719.3
(22) Date of filing: 25.04.2013
(51) Int. Cl.: H05K 7/14, H02B 1/04, H02B 1/052

(54) **ELECTRICAL DEVICE MOUNTING STRUCTURE**
MONTAGESTRUKTUR FÜR ELEKTRISCHE VORRICHTUNG
STRUCTURE DE MONTAGE DE DISPOSITIF ÉLECTRIQUE

(30) Priority: 27.04.2012 JP 2012103235; 27.04.2012 JP 2012103236
(43) Date of publication of application: 06.05.2015
(73) Proprietor: Idec Corporation, Osaka-shi Osaka 532-0004 (JP)
(72) Inventor: NIINAI, Hideo, Osaka-shi Osaka 532-0004 (JP); WATANABE, Tatsuhiro, Osaka-shi Osaka 532-0004 (JP)
(74) Representative: Müller-Boré & Partner Patentanwälte PartG mbB
(86) International application number: PCT/JP2013/062286
(87) International publication number: WO 2013/161962

(56) References cited:
- FR-A1- 2 789 814
- JP-A- 2003 298 252
- JP-A- 2005 135 945
- JP-A- 2006 068 852
- JP-U- H01 137 589
- JP-U- H01 137 589
- JP-U- H01 176 984
- JP-U- S59 125 883

## Description

### Technical Field

The present invention relates to a mounting structure for an electrical device.

### Background Art

Electrical devices such as a programmable controller (PLC), a relay, a timer, and a breaker have conventionally been mounted on support rails and mounting surfaces such as wall surfaces. In Japanese Patent Application Laid-Open No. 2003-298252 (Document 1), for example, first and second stoppers that are slidable in the same sliding direction are provided on the rear surface of the base of an electronic device body, and at the time of mounting on a support rail, a tip of the first stopper is locked in a position where it engages the support rail. The first and second stoppers each have a screw hole and are also locked in positions at which the screw holes project outwardly of the base when being slid into these positions. The electronic device is thus also able to be mounted on a support plate or the like.

Incidentally, in the mounting structure of Document 1, the first and second stoppers serving as sliding parts are each provided with an arc-shaped elastic locking piece that projects so as to be supported in a cantilever manner, and the sliding parts are locked by the locking pieces being locked in locking holes formed in the rear surface of the base, which serves as a mounting main body. In this locking mechanism, there is a possibility that the locking pieces will come out of the locking holes and the sliding parts will be unlocked when a large external force acts on the electrical device. In the case where the electrical device is mounted on the mounting surface by using the screw holes provided in the two sliding parts (i.e., in the case of direct mounting), the electrical device could possibly be detached from the mounting surface along with the mounting main body if the sliding parts are unlocked.

JP H01 137 589 U discloses a mounting structure for an electrical device according to the preamble of claim 1 comprising a mounting main body and a sliding part. FR 2 789 814 A1 discloses a locking structure for locking an electrical command module on a command panel.

JP 2006068852 A discloses a mounting structure for only rail mounting.

JP 359125883 U discloses another mounting structure for rail and wall mounting.

### Summary of Invention

The present invention is intended for a mounting structure for an electrical device, and it is an object of the present invention to securely fix a sliding part to a mounting main body in the case of direct mounting.

The mounting structure for an electrical device according to the present invention includes a mounting main body that supports or houses an electrical device, and a sliding part that is movable in a sliding direction along a bottom surface of the mounting main body by a guide part provided on the bottom surface. The sliding part includes a main body, a through hole for insertion of a mounting screw, and a sliding engagement part that engages a projecting position locking part formed on the bottom surface, when the sliding part is disposed at a projecting position at which the through hole is located outwardly of a side surface of the mounting main body. Said projecting position locking part is a groove and said sliding engagement part is provided in a vicinity of a free end of a member supported in a cantilever manner and has a raised portion projecting farther on a side of said bottom surface than said main body in said sliding part. In a state in which the sliding part is disposed at the projecting position and the mounting main body is directly mounted on a mounting surface, both sides of the sliding engagement part in a direction perpendicular to the bottom surface are in direct contact with the projecting position locking part and the mounting surface.

According to the present invention, it is possible to securely fix the sliding part to the mounting main body in the case of direct mounting on the mounting surface.

In a preferred embodiment of the present invention, the mounting structure for an electrical device further includes another sliding part that is movable in a sliding direction along the bottom surface by another guide part provided on the bottom surface. The other sliding part includes a through hole for insertion of a mounting screw, and a sliding engagement part that engages a projecting position locking part formed in a raised or recessed shape on the bottom surface, when the other sliding part is disposed at a projecting position at which the through hole is located outwardly of a side surface of the mounting main body. In a state in which the other sliding part is disposed at the projecting position and the mounting main body is directly mounted on the mounting surface, both sides of the sliding engagement part in a direction perpendicular to the bottom surface are in direct or indirect contact with the projecting position locking part and the mounting surface. Accordingly, it is possible to securely fix the other sliding part to the mounting main body in the case of direct mounting.

In this case, it is preferable that the sliding direction of the sliding part differs from the sliding direction of the other sliding part.

In another preferred embodiment of the present invention, the mounting structure for an electrical device further includes another sliding part that is movable in another sliding direction extending along the bottom surface and different from the sliding direction by another guide part provided on the bottom surface, and a rail engagement part that is provided on the bottom surface, and that engages one edge extending along a longitudinal direction of a long support rail when the mounting main body is mounted on the support rail. In a case where the mounting main body is directly mounted on the mounting surface, the sliding part is disposed at the projecting position, and the other sliding part is disposed at a projecting position at which a through hole that is formed in the other sliding part and that is for insertion of a mounting screw is located outwardly of a side surface of the mounting main body. In a case where the mounting main body is mounted on the support rail, one of the sliding part and the other sliding part is disposed at a rail engagement position to engage the other edge extending along the longitudinal direction of the support rail. Accordingly, in the mounting structure that enables direct mounting on the mounting surface and mounting on the support rail through movement of the two sliding parts, it is possible to prevent the mounting main body from moving greatly in any direction in the case of direct mounting.

In yet another preferred embodiment of the present invention, the sliding part further includes another sliding engagement part that engages another projecting position locking part formed in a raised or recessed shape on the bottom surface, when the sliding part is disposed at the projecting position. In a state in which the sliding part is disposed at the projecting position and the mounting main body is directly mounted on the mounting surface, both sides of the other sliding engagement part in a direction perpendicular to the bottom surface are in direct or indirect contact with the other projecting position locking part and the mounting surface. Accordingly, it is possible to more securely fix the sliding part to the mounting main body.

These and other objects, features, aspects and advantages of the present invention will become more apparent from the following detailed description of the present invention when taken in conjunction with the accompanying drawings.

### Brief Description of Drawings

Fig. 1 is a perspective view of a mounting structure for an electrical device;
Fig. 2 is an exploded view of the mounting structure;
Fig. 3 is a perspective view of the mounting structure;
Fig. 4 is a bottom view of the mounting structure;
Fig. 5 is a cross-sectional view of the mounting structure;
Fig. 6 is a bottom view of the mounting structure;
Fig. 7 is a cross-sectional view of the mounting structure;
Fig. 8 is a bottom view of a mounting structure according to a comparative example;
Fig. 9 is a cross-sectional view of the mounting structure of the comparative example; and
Fig. 10 is a cross-sectional view of a mounting structure according to another example.

### Description of Embodiments

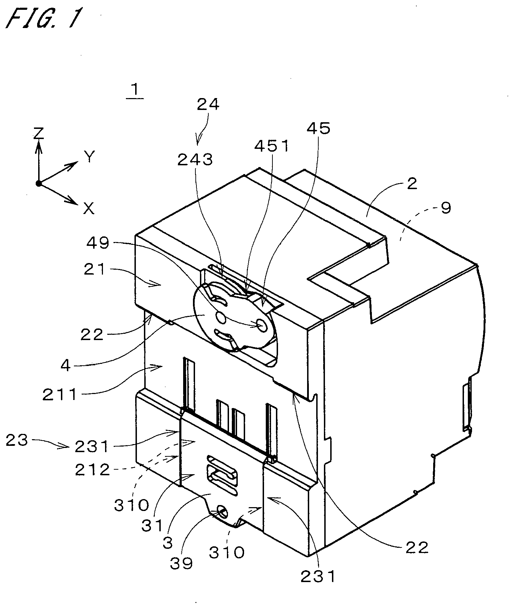

Fig. 1 is a perspective view of a mounting structure 1 for an electrical device 9 according to an embodiment of the present invention. The electrical device 9 may be a programmable controller (PLC), a relay, a timer, or a breaker, for example. The mounting structure 1 includes a box-like mounting main body 2 that houses the electrical device 9, and a first sliding part 3 and a second sliding part 4 are provided on one surface 21 (-Y-side surface in Fig. 1) of the mounting main body 2. The mounting main body 2, the first sliding part 3, and the second sliding part 4 are made of a resin, for example. When mounted on a support rail or a mounting surface, which will be described later, the mounting structure 1 is often mounted such that the surface 21 is upright (of course, the mounting structure 1 may be mounted in other orientations). However, in the following description, the surface 21 of the mounting main body 2 is referred to as a "bottom surface 21" because the mounting structure 1 before mounting is often handled with the surface 21 facing downward in the vertical direction. In Fig. 1, two directions that extend approximately along the bottom surface 21 and that are orthogonal to each other are referred to as "X and Z directions," and a direction that is approximately perpendicular to the bottom surface 21 is referred to as a "Y direction" (the same applies below). In the mounting structure 1 of Fig. 1, the bottom surface 21 has a rectangular external form having sides parallel to the X and Z directions.

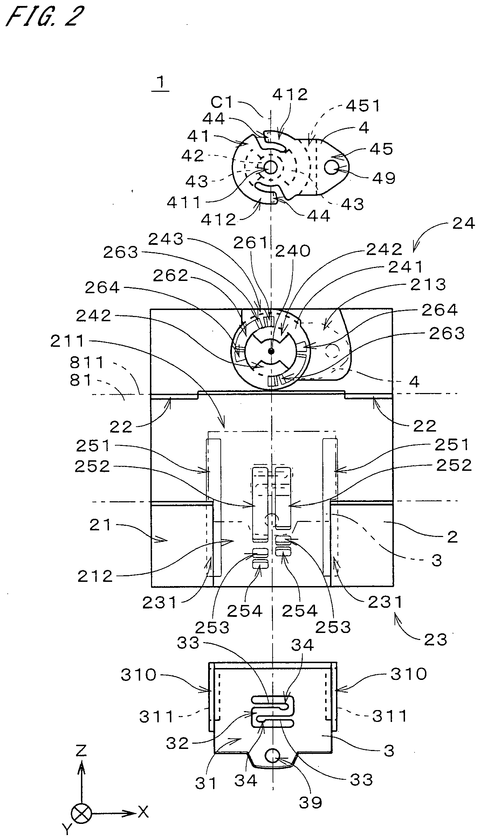

Fig. 2 is an exploded view of the mounting structure 1 and separately illustrates the mounting main body 2, the first sliding part 3, and the second sliding part 4 as viewed in the +Y direction from the -Y side in Fig. 1. In the bottom surface 21 of the mounting main body 2 is formed a groove 211 (hereinafter, referred to as a "rail groove 211") that extends in the lateral direction (X direction) in Fig. 2. As will be described later, in the case where the mounting main body 2 is mounted on a long support rail 81 (e.g., a DIN rail indicated by a dashed double-dotted line in Fig. 2), the support rail 81 is fitted into the rail groove 211. The first sliding part 3 and the second sliding part 4 are respectively disposed on the -Z side and +Z side of the rail groove 211 as illustrated in Fig. 1. In other words, the rail groove 211 is formed between the first sliding part 3 and the second sliding part 4.

As illustrated in Fig. 2, two rail engagement parts 22 that project on the -Z side are provided at the +Z-side edge of the rail groove 211. The two rail engagement parts 22 are disposed at both end portions of the rail groove 211 in the X direction, and when the mounting main body 2 is mounted on the support rail 81, one edge 811 that extends along the longitudinal direction of the support rail 81 is sandwiched and held between the rail engagement parts 22 and the bottom surface (surface perpendicular to the Y direction) of the rail groove 211. In other words, the rail engagement parts 22 engage one edge 811 of the support rail 81.

In the bottom surface 21 of the mounting main body 2 is formed a groove 212 (a groove that is used to move the first sliding part 3 and is hereinafter referred to as a "slide groove 212") that extends in the -Z direction from the X-directional center of the rail groove 211. The slide groove 212 has a protruding portion 231 that is formed at the -X-side edge and that protrudes on the +X side, and another protruding portion 231 that is formed at the +X-side edge and that protrudes on the -X side. A rectangular thin-plate main body 31 of the first sliding part 3 has opposite end portions 310 in the X direction that are thinner than other portions thereof and that are sandwiched and held between the bottom surface (surface perpendicular to the Y direction) of the slide groove 212 and the protruding portions 231 (see Fig. 1). In this way, a first guide part 23 that includes the two protruding portions 231 supports the first sliding part 3 such that the first sliding part 3 is movable in a direction extending along the bottom surface 21 of the mounting main body 2 and in which the slide groove 212 extends (i.e., Z direction, which is hereinafter referred to as a "first sliding direction"). Note that the -Y-side surface of the first sliding part 3 when supported by the first guide part 23 is approximately in the same plane as the area of the bottom surface 21, excluding the grooves 211 and 212 and a recessed portion 213, which will be described later.

In the vicinity of the end portions 310 of the first sliding part 3 in Fig. 2 are provided portions 311 that project slightly on the +Y side, and the slide groove 212 has two auxiliary grooves 251 at the bottom to allow the portions 311 to slide therein. Between the two auxiliary grooves 251, there are two other auxiliary grooves 252 that are used when the first sliding part 3 is attached on the mounting main body 2. On the -Z side of each of the auxiliary grooves 252 are provided two grooves 253 and 254 that are arranged in the Z direction.

The main body 31 of the first sliding part 3 has an opening 32 approximately in the middle, and the opening 32 has a generally rectangular external form. At the -X-side edge of the opening 32 is provided a long member 33 that projects on the +X side and the tip of which is located in the vicinity of the +X-side edge of the opening 32. At the +X-side edge of the opening 32 is provided another long member 33 that projects on the -X side and the tip of which is located in the vicinity of the -X-side edge of the opening 32. In this way, the two plate-spring long members 33 that extend approximately along the X direction and that are supported in a cantilever manner are formed at the opening 32 of the first sliding part 3 so as to be arranged in the Z direction. Each of the long members 33 has a sliding engagement part 34 provided in the vicinity of the free end. The sliding engagement parts 34 project slightly farther on the +Y side than the main body 31 and the long members 33.

In the case where the first sliding part 3 is attached on the mounting main body 2, the first sliding part 3 is disposed on the +Z side of the first guide part 23 as indicated by a dashed double-dotted line in Fig. 2 and then is moved in the -Z direction so that both of the end portions 310 are inserted between the bottom surface of the slide groove 212 and both of the protruding portions 231. At this time, the portions 311 of the end portions 310 slide in the auxiliary grooves 251, and the sliding engagement parts 34 slide in the auxiliary grooves 252. When the sliding engagement parts 34 have reached the -Z-side ends of the auxiliary grooves 252 and the first sliding part 3 has been pushed in the -Z direction, the sliding engagement parts 34 are disposed in and engage the grooves 253, and movement of the first sliding part 3 is locked (i.e., the position of the first sliding part 3 is locked). Accordingly, the first sliding part 3 is disposed at the position in Fig. 1 (hereinafter, referred to as a "rail engagement position"). At the rail engagement position, most of the first sliding part 3 overlaps with the bottom surface 21 in the Y direction. In the following description, the grooves 253 in Fig. 2 are referred to as "engagement position locking parts 253."

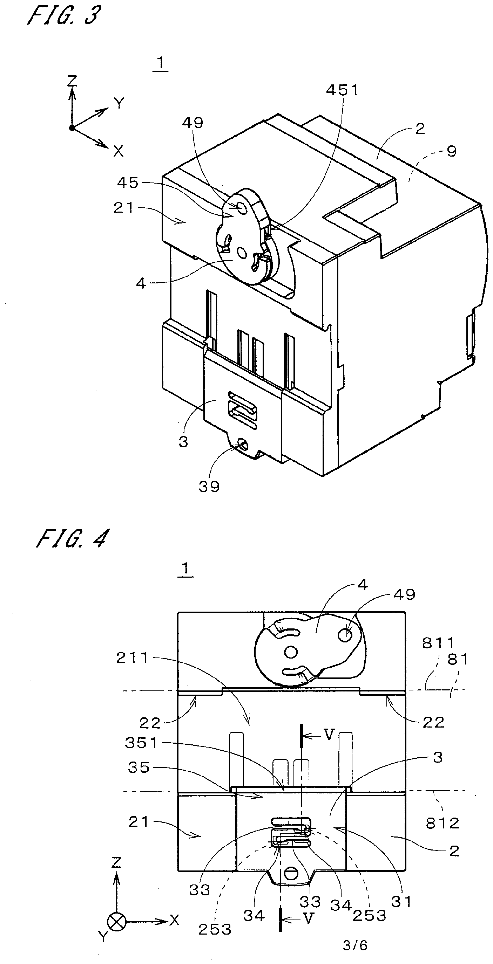

When the first sliding part 3 is further pushed in the -Z direction, the sliding engagement parts 34 are disposed in and engage the grooves 254, and movement of the first sliding part 3 is locked. Accordingly, the first sliding part 3 is disposed at the position in Fig. 3 (hereinafter, referred to as a "first projecting position"). At the first projecting position, a through hole 39 (hereinafter, referred to as a "first through hole 39") that is formed in the -Z-side end portion of the first sliding part 3 is located outwardly of the -Z-side side surface of the mounting main body 2. The first through hole 39 is a hole for insertion of a mounting screw, which will be described later. In the following description, the grooves 254 in Fig. 2 are referred to as "projecting position locking parts 254."

In the bottom surface 21 of the mounting main body 2 on the +Z side of the rail groove 211 is formed the recessed portion 213, and a second guide part 24 is provided in the recessed portion 213. To be specific, the second guide part 24 has an approximately annular main body 241 formed on the bottom surface (surface perpendicular to the Y direction) of the recessed portion 213. A central axis 240 of the main body 241 that is parallel to the Y direction is disposed on a center line C1 of the bottom surface 21 that is parallel to the Z direction. At the -Y-side end of the main body 241 are provided two thin-plate protruding portions 242 that protrude toward the central axis 240. The two protruding portions 242 are disposed on the +Z side and -Z side of the central axis 240.

The second sliding part 4 includes a generally disk-shaped main body 41 and a main body protruding portion 45 that communicates with the main body 41, and the main body 41 has a center hole 411 in the middle. On the +Y-side surface of the main body 41, a cylindrical portion 42 is provided around the center hole 411, and two thin-plate protruding portions 43 that respectively protrude in the +X and -X directions are provided at the +Y-side end of the cylindrical portion 42. As viewed in the Y direction, the two protruding portions 43 are of an arc shape along the outer edge of the cylindrical portion 42. In the second guide part 24, an opening that is defined by the inner edge of the main body 241 and the edges of the two arc-shaped protruding portions 242 extending along the inner edge has a form following the external forms of the cylindrical portion 42 and the two protruding portions 43, which are described above. Accordingly, the two protruding portions 43 and the cylindrical portion 42 are insertable into the inside of the main body 241 of the second guide part 24 through the opening. In Fig. 2, part of the second sliding part 4 when the two protruding portions 43 and the cylindrical portion 42 are inserted in the inside of the second guide part 24 is indicated by a dashed double-dotted line.

The second sliding part 4 is rotatable about the central axis 240 in the couterclockwise direction from the position indicated by the dashed double-dotted line in Fig. 2. With the second sliding part 4 rotated, part of the protruding portions 43 of the second sliding part 4 is disposed on the +Y side of the protruding portions 242 of the second guide part 24. In this way, the second sliding part 4 is supported by the second guide part 24 so as to be movable (rotatable) in the direction of rotation about the central axis 240 (hereinafter, referred to as a "second sliding direction"). Note that the -Y-side surface of the second sliding part 4 when supported by the second guide part 24 is approximately in the same plane as the area of the bottom surface 21, excluding the grooves 211 and 212 and the recessed portion 213.

In the vicinity of the outer edge of the +Y-side surface of the main body 41 of the second sliding part 4 (in the vicinity of arc-shaped portions 412, which will be described later) are provided portions that project slightly on the +Y side (portions indicated by thin broken lines in Fig. 2), and these portions and portions of the main body 41 that approximately overlap with these portions in the Y direction constitute sliding engagement parts 44. In other words, the sliding engagement parts 44 are portions in the vicinity of the tips of the arc-shaped portions 412, which will be described later. The second sliding part 4 has two sliding engagement parts 44, and the two sliding engagement parts 44 are disposed at positions that are point symmetric with respect to the center (center hole 411) of the main body 41. The -Y-side surface of the main body 241 of the second guide part 24 has two grooves 261 (in Fig. 2, one of the grooves is indicated by reference numeral 261; the same applies to grooves 262, which will be described later) in which the two sliding engagement parts 44 of the second sliding part 4 with the protruding portions 43 and the cylindrical portion 42 inserted in the second guide part 24 (i.e., the second sliding part 4 indicated by the dashed double-dotted line in Fig. 2) are to be disposed. This surface of the main body 241 also has grooves 263, 262, and 264 that are adjacent to each of the grooves 261 in order in the counterclockwise direction about the central axis 240 in Fig. 2. Note that the grooves 262 are shallower than the other grooves 261, 263, and 264.

In the case where the second sliding part 4 is attached on the mounting main body 2, the protruding portions 43 and the cylindrical portion 42 of the second sliding part 4 are inserted into the second guide part 24 as described previously. At this time, the sliding engagement parts 44 (specifically, the +Y-side portions of the sliding engagement parts 44) are disposed in the grooves 261. Then, the second sliding part 4 is rotated at a slight angle in the counterclockwise direction about the central axis 240 in Fig. 2, which causes the sliding engagement parts 44 to be disposed in and engage the grooves 263 and locks movement of the second sliding part 4 (i.e., the position of the second sliding part 4 is locked). Accordingly, the second sliding part 4 is disposed at the position in Fig. 1 (hereinafter, referred to as a "retracted position"). At the retracted position, the entire second sliding part 4 overlaps with the bottom surface 21 in the Y direction. In the following description, the grooves 263 in Fig. 2 are referred to as "retracted position locking parts 263."

The main body 41 of the second sliding part 4 has the two arc-shaped portions 412 that extend along the circumferential direction about the center hole 411, and the portions 412 are supported in a cantilever manner by the main body 41. The sliding engagement parts 44 are formed at the tips (free ends) of these plate-spring portions 412, and when the sliding engagement parts 44 move from the grooves 261 to the grooves 263, the portions 412 become deformed to allow the second sliding part 4 to be moved (rotated) by a relatively small force (the same applies to movement from the grooves 263 to the grooves 264 through the grooves 262, which will be described later).

When the second sliding part 4 is further rotated in the counterclockwise direction, the sliding engagement parts 44 slide in the relatively shallow grooves 262 and reach the ends of the grooves 262. When the second sliding part 4 is further rotated at only a slight angle in the counterclockwise direction, the sliding engagement parts 44 are disposed in and engage the grooves 264, and movement of the second sliding part 4 is locked. Accordingly, the second sliding part 4 is disposed at the position in Fig. 3 (hereinafter, referred to as a "second projecting position"). In the following description, the grooves 264 in Fig. 2 are referred to as "projecting position locking parts 264." At the second projecting position, a through hole 49 (hereinafter, referred to as a "second through hole 49") that is formed in the main body protruding portion 45 of the second sliding part 4 is located outwardly of the +Z-side side surface of the mounting main body 2. The second through hole 49 is a hole for insertion of a mounting screw, which will be described later.

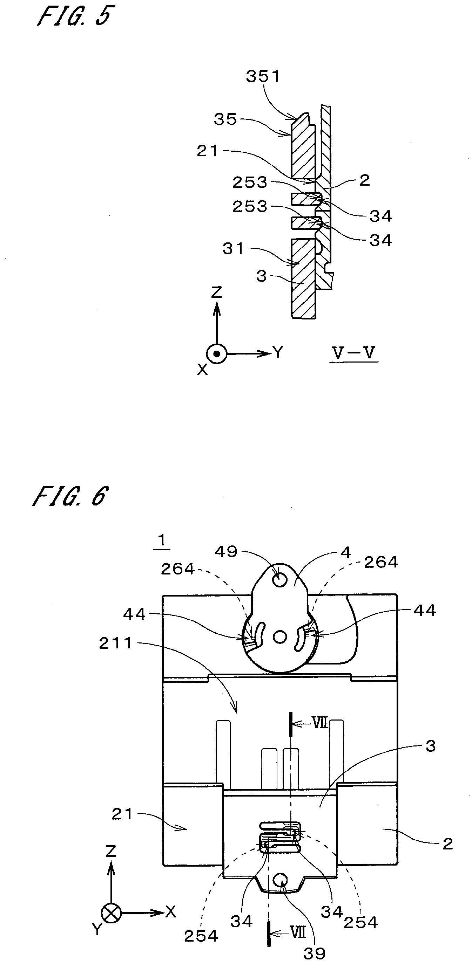

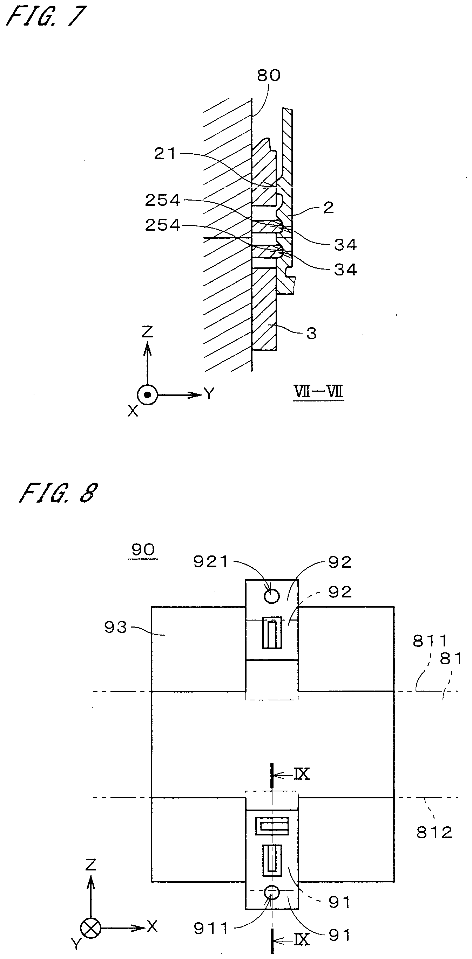

Fig. 4 is a bottom view of the mounting structure 1 and illustrates a state in which the first sliding part 3 and the second sliding part 4 are respectively disposed at the rail engagement position and the retracted position. Fig. 5 is a cross-sectional view taken at a position indicated by an arrow V-V in Fig. 4 and illustrates only the vicinity of the first sliding part 3 and the bottom surface 21 of the mounting main body 2. Note that Fig. 5 illustrates each member larger than the actual thickness in the Y direction (the same applies to Fig. 7, which will be described later).

In the case where the mounting main body 2 is mounted on the support rail 81, the first sliding part 3 is disposed at the rail engagement position. One edge 811 extending along the longitudinal direction of the support rail 81 is then sandwiched between the rail engagement parts 22 and the bottom surface (surface perpendicular to the Y direction) of the rail groove 211, while the other edge 812 of the support rail 81 is pushed against a +Z-side end portion 35 of the first sliding part 3. As illustrated in Fig. 5, the -Y-side surface of the end portion 35 of the first sliding part 3 includes an inclined surface 351 along which the Y-directional thickness of the main body 31 gradually decreases toward the +Z direction. As described previously, the sliding engagement parts 34 locked in the engagement position locking parts 253 in Fig. 4 are provided in the vicinity of the free ends of the long members 33 that extend in the X direction. Accordingly, as the edge 812 of the support rail 81 is pushed in against the inclined surface 351 in the +Y direction, the long members 33 become elastically deformed, and the main body 31 of the first sliding part 3 moves in the first sliding direction (to be precise, the -Z direction) perpendicular to the longitudinal direction of the support rail 81.

Then, when the edge 812 of the support rail 81 has passed through the +Z side of the end portion 35 of the first sliding part 3 and reached the bottom surface of the rail groove 211, the first sliding part 3 returns to the original position (the position in Fig. 4 at which the long members 33 are not deformed), and the edge 812 of the support rail 81 is sandwiched and held between the end portion 35 of the first sliding part 3 and the bottom surface of the rail groove 211. In other words, the first sliding part 3 engages the edge 812 of the support rail 81 at the rail engagement position. Note that because the second sliding part 4 is not used in the case of mounting the mounting main body 2 on the support rail 81, the second sliding part 4 is disposed at the retracted position at which the second through hole 49 is located on the bottom surface 21, and the second sliding part 4 entirely overlaps with the bottom surface 21. Thus, the second sliding part 4 will interfere with neither the mounting operation nor the disposition of other members in the case of mounting the mounting main body 2 on the support rail 81.

Fig. 6 is a bottom view of the mounting structure 1 and illustrates a state in which the first sliding part 3 and the second sliding part 4 are respectively disposed at the first projecting position and the second projecting position. Fig. 7 is a cross-sectional view taken at a position indicated by an arrow VII-VII in Fig. 6 and illustrates only the vicinity of the first sliding part 3 and the bottom surface 21 of the mounting main body 2.

In the case where the mounting main body 2 is directly mounted on a mounting surface, the first sliding part 3 is pulled out to the first projecting position and the second sliding part 4 is pulled out to the second projecting position. Accordingly, the first through hole 39 of the first sliding part 3 and the second through hole 49 of the second sliding part 4 are both located outwardly of the side surfaces of the mounting main body 2. Then, the mounting main body 2 is directly mounted on the mounting surface by inserting a mounting screw into each of the through holes 39 and 49 and tightening the screws to the mounting surface. At this time, as illustrated in Fig. 7, both sides of each sliding engagement part 34 in the Y direction perpendicular to the bottom surface 21 are brought into contact with the projecting position locking part 254 and the mounting surface 80. In other words, the sliding engagement part 34 is sandwiched between the projecting position locking part 254 and the mounting surface 80. Accordingly, the first sliding part 3 is securely fixed to the mounting main body 2. Similarly, in the second sliding part 4 in Fig. 6, both sides of the sliding engagement parts 44 in the Y direction are brought into contact with the projecting position locking parts 264 and the mounting surface 80. Accordingly, the second sliding part 4 is securely fixed to the mounting main body 2.

As illustrated in Figs. 1 and 2, the main body 241 of the second guide part 24 has a plate-like auxiliary protruding portion 243 on the +Z side, and the main body protruding portion 45 of the second sliding part 4 has an engagement groove 451 that is formed to receive insertion of the auxiliary protruding portion 243 when the second sliding part 4 is disposed at the second projecting position. Accordingly, even if a force in the direction perpendicular to the bottom surface 21 of the mounting main body 2 acts on the main body protruding portion 45 when the second sliding part 4 is disposed at the second projecting position (position in Fig. 3), the contact between the inner surface of the engagement groove 451 and the auxiliary protruding portion 243 (see Fig. 1) of the second guide part 24 prevents the protruding portions 43 and the protruding portions 242 (see Fig. 2) of the second guide part 24, which support movement of the second sliding part 4, from being damaged.

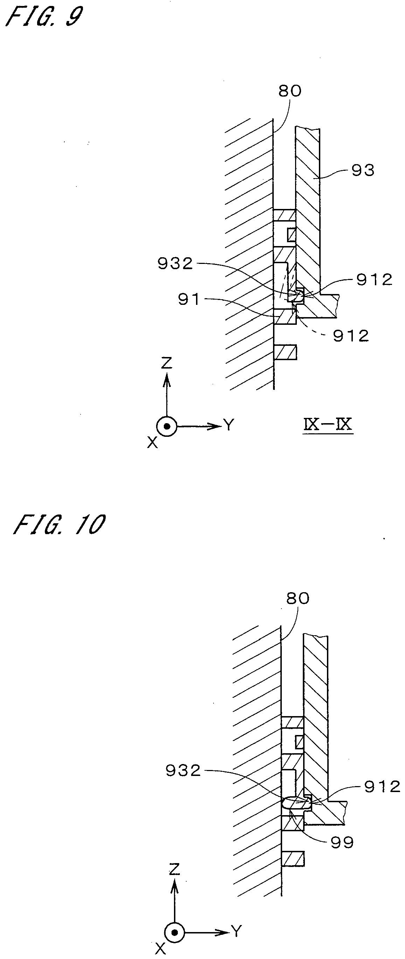

Fig. 8 is a bottom view of a mounting structure 90 according to a comparative example, and Fig. 9 is a cross-sectional view taken at a position indicated by an arrow IX-IX in Fig. 8. In the mounting structure 90 of the comparative example, a first sliding part 91 and a second sliding part 92 are both movable in the same sliding direction (Z direction in Fig. 8). In the case where a mounting main body 93 is mounted on the support rail 81, the first sliding part 91 and the second sliding part 92 are disposed at positions indicated by dashed double-dotted lines in Fig. 8 and engage both of the edges 812 and 811 of the support rail 81. In the case where the mounting main body 93 is directly mounted on a mounting surface, the first sliding part 91 and the second sliding part 92 are disposed at positions indicated by solid lines in Fig. 8, and the mounting main body 93 is mounted on the mounting surface 80, using through holes 911 and 921. In this case, in the first sliding part 91, engagement parts 912 provided at the tips of members supported in a cantilever manner engage locking holes 932 formed in the bottom surface of the mounting main body 93 as illustrated in Fig. 9. Accordingly, the first sliding part 91 is fixed (locked) to the mounting main body 93. The second sliding part 92 is also fixed to the mounting main body 93 with a similar mechanism.

In the locking mechanism of Fig. 9, however, a relatively large gap exists between the mounting surface 80 and the engagement parts 912. Thus, if a large force acts on the mounting main body 93, there is a possibility that the engagement parts 912 will come out of the locking holes 932 and the first sliding part 91 will be unlocked as indicated by dashed double-dotted lines in Fig. 9 (the same applies to the second sliding part 92). If both of the first sliding part 91 and the second sliding part 92 are unlocked, the mounting main body 93 will move greatly in the sliding direction (Z direction).

In contrast, in the mounting structure 1 in a state in which the first sliding part 3 is disposed at the first projecting position and the mounting main body 2 is directly mounted on the mounting surface 80, both sides of the sliding engagement parts 34 in the direction perpendicular to the bottom surface 21 of the mounting main body 2 are in contact with the projecting position locking parts 254 and the mounting surface 80. This prevents the sliding engagement parts 34 from becoming detached from the projecting position locking parts 254 and allows the first sliding part 3 to be securely fixed to the mounting main body 2 in the case of direct mounting on the mounting surface 80. In a state in which the second sliding part 4 is disposed at the second projecting position and the mounting main body 2 is directly mounted on the mounting surface 80, both sides of the sliding engagement parts 44 in the direction perpendicular to the bottom surface 21 of the mounting main body 2 are in contact with the projecting position locking parts 264 and the mounting surface 80. This allows the second sliding part 4 to be securely fixed to the mounting main body 2.

In the case of direct mounting on the mounting surface 80, the provision of a plurality of sliding engagement parts 34, which are brought into contact with the projecting position locking parts 254 and the mounting surface 80, in the first sliding part 3 allows the first sliding part 3 to be more securely fixed to the mounting main body 2. Also, the provision of a plurality of sliding engagement parts 44, which are brought into contact with the projecting position locking parts 264 and the mounting surface 80, in the second sliding part 4 allows the second sliding part 4 to be more securely fixed to the mounting main body 2.

In the mounting structure 1, the first sliding direction of the first sliding part 3 differs from the second sliding direction of the second sliding part 4. Accordingly, in the mounting structure 1 that allows selection between direct mounting on the mounting surface 80 and mounting on the support rail 81 through movement of the two sliding parts 3 and 4, it is possible, in the case of direct mounting, to prevent the mounting main body 2 from moving greatly in any direction even if both of the first sliding part 3 and the second sliding part 4 are unlocked. In other words, with the mounting structure 1 in which the first guide part 23 and the second guide part 24 prevent the mounting main body 2, which is directly mounted on the mounting surface 80, from moving greatly in any direction, it is possible to more reliably prevent the engagement between the sliding engagement parts 34 and 44 and the projecting position locking parts 254 and 264 from being released.

In addition, the second sliding direction of the second sliding part 4 is the direction of rotation about the central axis 240 perpendicular to the bottom surface 21 of the mounting main body 2. Thus, a member (in the above example, the engagement groove 451 of the second sliding part 4 and the auxiliary protruding portion 243 of the second guide part 24) that resists a force acting in the Y-direction on the portion of the second sliding part 4 that projects from the side surface of the mounting main body 2, in a state in which the second sliding part 4 is disposed at the second projecting position, can be easily provided in the vicinity of the portion of the second sliding part 4.

While the above has been a description of an embodiment of the present invention, the present invention is not intended to be limited to the embodiment described above, and various modifications are possible.

The first sliding direction and the second sliding direction may be various directions along the bottom surface 21 of the mounting main body 2, and for example, the first sliding direction of the first sliding part 3 may be a direction of rotation about an axis perpendicular to the bottom surface 21. In this case, the first sliding part 3 is provided with a portion that projects on the rail groove 211 side when the first sliding part 3 is disposed at the rail engagement position, and this portion engages the edge 812 of the support rail 81 when the mounting main body 2 is mounted on the support rail 81. The first guide part 23 and the second guide part 24 provided on the bottom surface 21 of the mounting main body 2 may employ various structures other than the structures described above.

In the above-described embodiment, the engagement position locking parts 253, the projecting position locking parts 254 and 264, and the retracted position locking parts 263 are formed in a recessed shape on the bottom surface 21 of the mounting main body 2 and engage the sliding engagement parts 34 and 44 having raised portions. However, the engagement position locking parts 253, the projecting position locking parts 254 and 264, and the retracted position locking parts 263 may be formed in a raised shape on the bottom surface 21 of the mounting main body 2 and engage sliding engagement parts 34 and 44 having recessed portions. A configuration is also possible in which the engagement part 912 of the comparative example is additionally provided with a portion 99 that projects on the -Y side as illustrated in Fig. 10, and in a state in which one end of the engagement part 912 (sliding engagement part) in the Y direction is in (direct) contact with the locking hole 932, the portion 99, i.e., the other end of the engagement part 912, is brought into contact with the mounting surface 80 so as to securely fix the sliding part to the mounting main body. In this case, the portion that is brought into contact with the locking hole 932 and the portion that is brought into contact with the mounting surface 80 may be disposed at positions that are slightly shifted from each other in the direction along the bottom surface of the mounting main body. Alternatively, the portion 99 may be provided separately from the engagement part 912 and the mounting surface 80, in which case the engagement part 912 is in indirect contact with the mounting surface 80 via the independent member. As described above, in order to securely fix the first sliding part and the second sliding part to the mounting main body in the case of direct mounting on the mounting surface 80, it is important for both sides of the sliding engagement parts to be in direct or indirect contact with the projecting position locking parts and the mounting surface.

A configuration is possible, for example, in which the engagement position locking part 253 on the -X side and the projecting position locking part 254 on the +X side in Fig. 2 are omitted, and only one of the sliding engagement parts 34 engages the engagement position locking part 253 when the first sliding part 3 is disposed at the rail engagement position, and only the other one of the sliding engagement parts 34 engages the projecting position locking part 254 when the first sliding part 3 is disposed at the first projecting position. In other words, the sliding engagement parts 34 that respectively lock the first sliding part 3 at the rail engagement position and the first projecting position may be different members.

In the mounting structure 1 of Fig. 1, the first sliding part 3 and the second sliding part 4 are locked at the first projecting position and the second projecting position when the mounting main body 2 is directly mounted on the mounting surface 80. However, even if one or both of the first sliding part 3 and the second sliding part 4 are not locked in the case of the direct mounting, it is possible, with the mounting structure 1 in which the first sliding direction differs from the second sliding direction, to prevent the mounting main body 2 from moving greatly in any direction, i.e., to fix the mounting main body 2 against external forces acting in any direction.

In the mounting structure 1 of Fig. 1, the second sliding part 4 does not contribute to the mounting of the mounting main body 2 on the support rail 81. Thus, the position of the second sliding part 4 in the case of mounting the mounting main body 2 on the support rail 81 may be arbitrarily determined. Also, the second sliding part 4 may be provided with a portion that projects on the rail groove 211 side when the second sliding part 4 is disposed at the retracted position, and this portion may engage one edge 811 of the support rail 81 when the mounting main body 2 is mounted on the support rail 81. In this case, the rail engagement part 22 provided on the bottom surface 21 of the mounting main body 2 in Fig. 1 may be omitted. In other words, the rail engagement part that engages one edge 811 of the support rail 81 when the mounting main body 2 is mounted on the support rail 81 may be realized by the second sliding part 4 disposed at the retracted position.

The mounting structure 1 may also be configured such that the second sliding part 4 is omitted and a portion with a hole is formed in advance on the +Z-side side surface of the mounting main body 2, for example. However, from the viewpoint of reducing the area occupied by the mounting structure 1 when mounted on the support rail 81, it is preferable for the mounting structure 1 to be provided with the second sliding part 4 that is capable of entirely overlapping with the bottom surface 21 of the mounting main body 2.

The mounting main body 2 of the mounting structure 1 may, for example, be a member that supports the electrical device 9 by fixing one surface of the electrical device 9, other than a member that houses the electrical device 9.

The configurations of the above-described preferred embodiment and variations may be appropriately combined as long as there are no mutual inconsistencies.

While the invention has been shown and described in detail, the foregoing description is in all aspects illustrative and not restrictive. It is therefore to be understood that numerous modifications and variations can be devised without departing from the scope of the invention as defined by the claims.

### Reference Signs List

- 1: Mounting structure
- 2: Mounting main body
- 3: First sliding part
- 4: Second sliding part
- 9: Electrical device
- 21: Bottom surface
- 23: First guide part
- 24: Second guide part
- 34, 44: Sliding engagement part
- 39: First through hole
- 49: Second through hole
- 80: Mounting surface
- 254, 264: Projecting position locking part

## Claims

1. A mounting structure (1) for an electrical device (9), comprising:
a mounting main body (2) that supports or houses an electrical device (9); and
a sliding part (3, 4) that is movable in a sliding direction along a bottom surface (21) of said mounting main body (2) by a guide part provided on said bottom surface,
wherein said sliding part includes:
a main body (31);
a through hole (39, 49) for insertion of a mounting screw; and
a sliding engagement part (34, 44) that engages a projecting position locking part (254, 264) formed on said bottom surface (21), when said sliding part (3, 4) is disposed at a projecting position at which said through hole (39, 49) is located outwardly of a side surface of said mounting main body (2), and
in a state in which said sliding part (3, 4) is disposed at said projecting position and said mounting main body (2) is directly mounted on a mounting surface (80), both sides of said sliding engagement part (34, 44) in a direction perpendicular to said bottom surface (21) are in direct contact with said projecting position locking part (254, 264) and said mounting surface (80),
**characterized in that**
said projecting position locking part (254, 264) is a groove (254),
said sliding engagement part (34, 44) is provided in a vicinity of a free end of a member (33, 412) supported in a cantilever manner and has a raised portion projecting farther on a side of said bottom surface (21) than said main body in said sliding part (3, 4).

2. The mounting structure for an electrical device according to claim 1, further comprising:
another sliding part (3, 4) that is movable in a sliding direction along said bot-torn surface (21) by another guide part (23, 24) provided on said bottom surface (21),
wherein said another sliding part (3, 4) includes:
a through hole (39, 49) for insertion of a mounting screw; and
a sliding engagement part (34, 44) that engages a projecting position locking part (254, 264) formed in a raised or recessed shape on said bottom surface (21), when said another sliding part (3, 4) is disposed at a projecting position at which said through hole (39, 49) is located outwardly of a side surface of said mounting main body (2), and
in a state in which said another sliding part (3, 4) is disposed at said projecting position and said mounting main body (2) is directly mounted on said mounting surface (80), both sides of said sliding engagement part (34, 44) in a direction perpendicular to said bottom surface (21) are in direct or indirect contact with said projecting position locking part (254, 264) and said mounting surface (80).

3. The mounting structure for an electrical device according to claim 2, wherein said sliding direction of said sliding part (3, 4) differs from said sliding direction of said another sliding part (3, 4).

4. The mounting structure for an electrical device according to claim 1, further comprising:
another sliding part (3, 4) that is movable in another sliding direction extending along said bottom surface (21) and different from said sliding direction by another guide part (23, 24) provided on said bottom surface (21); and
a rail engagement part (22) that is provided on said bottom surface (21), and that engages one edge (811) extending along a longitudinal direction of a long support rail (81) when said mounting main body (2) is mounted on said support rail (81),
wherein, in a case where said mounting main body (2) is directly mounted on said mounting surface (80), said sliding part (3, 4) is disposed at said projecting position, and said another sliding part (3, 4) is disposed at a projecting position at which a through hole (39, 49) that is formed in said another sliding part (3, 4) and that is for insertion of a mounting screw is located outwardly of a side surface of said mounting main body (2), and
in a case where said mounting main body (2) is mounted on said support rail (81), one of said sliding part (3, 4) and said another sliding part (3, 4) is disposed at a rail engagement position to engage the other edge (812) extending along said longitudinal direction of said support rail (81).

5. The mounting structure for an electrical device according to claim 4, wherein the sliding direction of said sliding part (3, 4) or said another sliding part (3, 4) is a direction of rotation about an axis perpendicular to said bottom surface (21).

6. The mounting structure for an electrical device according to any one of claims 1 to 5, wherein
said sliding part (3, 4) further includes another sliding engagement part (34, 44) that engages another projecting position locking part (254, 264) formed in a raised or recessed shape on said bottom surface (21), when said sliding part (3, 4) is disposed at said projecting position, and
in a state in which said sliding part (3, 4) is disposed at said projecting position and said mounting main body (2) is directly mounted on said mounting surface (80), both sides of said another sliding engagement part (34, 44) in a direction perpendicular to said bottom surface (21) are in direct or indirect contact with said another projecting position locking part (254, 264) and said mounting surface (80).

## Patentansprüche

1. Eine Befestigungsstruktur (1) für eine elektrische Vorrichtung (9), die Folgendes umfasst:
einen Montagehauptkörper (2), der eine elektrische Vorrichtung (9) trägt oder aufnimmt; und
ein Gleitteil (3, 4), das in einer Gleitrichtung entlang einer Bodenfläche (21) des genannten Montagehauptkörpers (2) durch ein auf der genannten Bodenfläche vorgesehenes Führungsteil beweglich ist,
wobei das genannte Gleitteil Folgendes beinhaltet:
einen Hauptkörper (31);
ein Durchgangsloch (39, 49) zum Einsetzen einer Montageschraube; und
ein Gleiteingriffsteil (34, 44), das mit einem auf der Bodenfläche (21) ausgebildeten Vorstehende-Position-Verriegelungsteil (254, 264) in Eingriff kommt, wenn das genannte Gleitteil (3, 4) an einer vorstehenden Position angeordnet ist, an der sich das genannte Durchgangsloch (39, 49) außerhalb einer Seitenfläche des genannten Montagehauptkörpers (2) und in einem Zustand befindet, in dem das genannte Gleitteil (3, 4) in der genannten vorstehenden Position angeordnet ist und der genannte Montagehauptkörper (2) direkt auf einer Montagefläche (80) montiert ist, wobei beide Seiten des genannten Gleiteingriffsteils (34, 44) in einer Richtung senkrecht zu der genannten Bodenfläche (21) in direktem Kontakt mit dem genannten Vorstehende-Position-Verriegelungsteil (254, 264) und der genannten Montagefläche (80) stehen,
**dadurch gekennzeichnet, dass**
das genannte Vorstehende-Position-Verriegelungsteil (254, 264) eine Nut (254) ist,
das genannte Gleiteingriffsteil (34, 44) in der Nähe eines freien Endes eines freitragend gelagerten Elements (33, 412) bereitgestellt wird und einen erhöhten Abschnitt aufweist, der auf einer Seite der genannten Bodenfläche (21) weiter vorsteht als der genannte Hauptkörper im genannten Gleitteil (3, 4).

2. Die Befestigungsstruktur für eine elektrische Vorrichtung nach Anspruch 1, die ferner Folgendes umfasst:
ein weiteres Gleitteil (3, 4), das beweglich ist in einer Gleitrichtung entlang der genannten Bodenfläche (21) durch ein weiteres Führungsteil (23, 24), das auf der genannten Bodenfläche (21) vorgesehen ist,
wobei das genannte weitere Gleitteil (3, 4) Folgendes beinhaltet:
ein Durchgangsloch (39, 49) zum Einsetzen einer Montageschraube; und
ein Gleiteingriffsteil (34, 44), das mit einem Vorstehende-Position-Verriegelungsteil (254, 264) in Eingriff kommt, das in einer erhöhten oder vertieften Form auf der genannten Bodenfläche (21) ausgebildet ist, wenn das genannte weitere Gleitteil (3, 4) an einer vorstehenden Position angeordnet ist, an der sich das genannte Durchgangsloch (39, 49) außerhalb einer Seitenfläche des genannten Montagehauptkörpers (2) befindet, und
wobei in einem Zustand, in dem das genannte weitere Gleitteil (3, 4) in der genannten vorstehenden Position angeordnet ist und der genannte Montagehauptkörper (2) direkt auf der genannten Montagefläche (80) montiert ist, beide Seiten des genannten Gleiteingriffsteils (34, 44) in einer Richtung senkrecht zur genannten Bodenfläche (21) in direktem oder indirektem Kontakt mit dem genannten Vorstehende-Position-Verriegelungsteil (254, 264) und der genannten Montagefläche (80) stehen.

3. Die Befestigungsstruktur für eine elektrische Vorrichtung nach Anspruch 2, wobei sich die genannte Gleitrichtung des genannten Gleitteils (3, 4) von der genannten Gleitrichtung des genannten weiteren Gleitteils (3, 4) unterscheidet.

4. Die Befestigungsstruktur für eine elektrische Vorrichtung nach Anspruch 1, die ferner Folgendes umfasst:
ein weiteres Gleitteil (3, 4), das in einer weiteren Gleitrichtung beweglich ist, die sich entlang der genannten Bodenfläche (21) erstreckt und sich von der genannten Gleitrichtung durch ein weiteres Führungsteil (23, 24) unterscheidet, das auf der genannten Bodenfläche (21) bereitgestellt wird; und
ein Schieneneingriffsteil (22), das auf der genannten Bodenfläche (21) bereitgestellt wird und mit einer Kante (811) in Eingriff kommt, die sich entlang einer Längsrichtung einer langen Tragschiene (81) erstreckt, wenn der genannte Montagehauptkörper (2) auf der genannten Tragschiene (81) montiert ist,
wobei in einem Fall, in dem der genannte Montagehauptkörper (2) direkt auf der genannten Montagefläche (80) montiert ist, das genannte Gleitteil (3, 4) an der genannten vorstehenden Position angeordnet ist, und das genannte andere Gleitteil (3, 4) an einer vorstehenden Position angeordnet ist, an der ein Durchgangsloch (39, 49), das im genannten weiteren Gleitteil (3, 4) ausgebildet ist und das zum Einsetzen einer Montageschraube dient, außerhalb einer Seitenfläche des genannten Montagehauptkörpers (2) angeordnet ist, und wobei
in einem Fall, in dem der genannte Montagehauptkörper (2) auf der genannten Tragschiene (81) montiert ist, eines der genannten Gleitteile (3, 4) und das genannte weitere Gleitteil (3, 4) an einer Schieneneingriffsposition angeordnet sind, um mit der weiteren Kante (812) in Eingriff zu kommen, die sich entlang der genannten Längsrichtung der genannten Tragschiene (81) erstreckt.

5. Die Befestigungsstruktur für eine elektrische Vorrichtung nach Anspruch 4, wobei die Gleitrichtung des genannten Gleitteils (3, 4) oder des genannten weiteren Gleitteils (3, 4) eine Drehrichtung um eine Achse senkrecht zur genannten Bodenfläche (21) ist.

6. Die Befestigungsstruktur für eine elektrische Vorrichtung nach irgendeinem der Ansprüche von 1 bis 5, wobei
das genannte Gleitteil (3, 4) ferner ein weiteres Gleiteingriffsteil (34, 44) beinhaltet, das mit einem weiteren Vorstehende-Position-Verriegelungsteil (254, 264) in Eingriff kommt, das in einer erhöhten oder vertieften Form auf der genannten Bodenfläche (21) ausgebildet ist, wenn das genannte Gleitteil (3, 4) an der genannten vorstehenden Position angeordnet ist, und wobei
in einem Zustand, in dem das genannte Gleitteil (3, 4) an der genannten vorstehenden Position angeordnet ist und der genannte Montagehauptkörper (2) direkt auf der genannten Montagefläche (80) montiert ist, beide Seiten des genannten weiteren Gleiteingriffsteils (34, 44) in einer Richtung senkrecht zur genannten Bodenfläche (21) in direktem oder indirektem Kontakt stehen mit dem genannten weiteren Vorstehende-Position-Verriegelungsteil (254, 264) und der genannten Montagefläche (80).

## Revendications

1. Une structure de montage (1) pour un dispositif électrique (9), comprenant :
un corps principal de montage (2) qui soutient ou abrite un dispositif électrique (9) ; et
une partie coulissante (3, 4) qui est mobile dans une direction de glissement le long d'une surface de fond (21) dudit corps principal de montage (2) par une partie de guidage prévue sur ladite surface de fond,
sachant que ladite partie coulissante inclut :
un corps principal (31) ;
un trou traversant (39, 49) pour l'insertion d'une vis de montage ; et
une partie d'engagement coulissante (34, 44) qui engage une partie de verrouillage de position saillante (*projecting position locking part*) (254, 264) formée sur ladite surface de fond (21), lorsque ladite partie coulissante (3, 4) est disposée dans une position saillante au niveau de laquelle ledit trou traversant (39, 49) est situé à l'extérieur d'une surface latérale dudit corps principal de montage (2), et dans un état dans lequel ladite partie coulissante (3, 4) est disposée à ladite position saillante et ledit corps principal de montage (2) est monté directement sur une surface de montage (80), les deux côtés de ladite partie d'engagement coulissante (34, 44) dans une direction perpendiculaire à ladite surface de fond (21) sont en contact direct avec ladite partie de verrouillage de position saillante (254, 264) et ladite surface de montage (80),
**caractérisée en ce que**
ladite partie de verrouillage de position saillante (254, 264) est une rainure (254),
ladite partie d'engagement coulissante (34, 44) est fournie à proximité d'une extrémité libre d'un élément (33, 412) soutenu en porte-à-faux et comporte une partie surélevée faisant saillie plus loin sur un côté de ladite surface de fond (21) que ledit corps principal dans ladite partie coulissante (3, 4).

2. La structure de montage pour un dispositif électrique d'après la revendication 1, comprenant en outre :
une autre partie coulissante (3, 4) qui est mobile dans une direction de glissement le long de ladite surface de fond (21) par une autre partie de guidage (23, 24) prévue sur ladite surface de fond (21),
sachant que ladite autre partie coulissante (3, 4) comprend :
un trou traversant (39, 49) pour l'insertion d'une vis de montage ; et
une partie d'engagement coulissante (34, 44) qui engage une partie de verrouillage de position saillante (254, 264) formée sous une forme en relief ou en creux sur ladite surface de fond (21), lorsque ladite autre partie coulissante (3, 4) est disposée à une position en saillie au niveau de laquelle ledit trou traversant (39, 49) est situé vers l'extérieur d'une surface latérale dudit corps principal de montage (2), et
dans un état dans lequel ladite autre partie coulissante (3, 4) est disposée à ladite position saillante, et ledit corps principal de montage (2) est monté directement sur ladite surface de montage (80), les deux côtés de ladite partie d'engagement coulissante (34, 44) dans une direction perpendiculaire à ladite surface de fond (21) sont en contact direct ou indirect avec ladite partie de verrouillage de position saillante (254, 264) et ladite surface de montage (80).

3. La structure de montage pour un dispositif électrique d'après la revendication 2, sachant que ladite direction de glissement de ladite partie coulissante (3, 4) diffère de ladite direction de glissement de ladite autre partie coulissante (3, 4).

4. La structure de montage pour un dispositif électrique d'après la revendication 1, comprenant en outre :
une autre partie coulissante (3, 4) qui est mobile dans une autre direction de glissement qui s'étend le long de ladite surface de fond (21) et qui est différente de ladite direction de glissement par une autre partie de guidage (23, 24) prévue sur ladite surface de fond (21) ; et
une partie d'engagement de rail (22) qui est prévue sur ladite surface de fond (21), et qui engage un bord (811) s'étendant le long d'une direction longitudinale d'un long rail de support (81) lorsque ledit corps principal de montage (2) est monté sur ledit rail de support (81),
sachant que, dans un cas où ledit corps principal de montage (2) est monté directement sur ladite surface de montage (80), ladite partie coulissante (3, 4) est disposée à ladite position saillante, et ladite autre partie coulissante (3, 4) est disposée à une position saillante à laquelle un trou traversant (39, 49), qui est formé dans ladite autre partie coulissante (3, 4) et qui est destiné à l'insertion d'une vis de montage, est situé à l'extérieur d'une surface latérale dudit corps principal de montage (2), et
dans un cas où ledit corps principal de montage (2) est monté sur ledit rail de support (81), l'un parmi ladite partie coulissante (3, 4) et ladite autre partie coulissante (3, 4) est disposée à une position d'engagement de rail pour engager l'autre bord (812) s'étendant le long de ladite direction longitudinale dudit rail de support (81).

5. La structure de montage pour un dispositif électrique d'après la revendication 4, sachant que la direction de glissement de ladite partie coulissante (3, 4) ou de ladite autre partie coulissante (3, 4) est une direction de rotation autour d'un axe perpendiculaire à ladite surface de fond (21).

6. La structure de montage pour un dispositif électrique d'après l'une quelconque des revendications de 1 à 5, sachant que
ladite partie coulissante (3, 4) inclut en outre une autre partie d'engagement coulissante (34, 44) qui engage une autre partie de verrouillage de position saillante (254, 264) formée sous une forme en relief ou en creux sur ladite surface de fond (21), lorsque ladite partie coulissante (3, 4) est disposée dans ladite position saillante, et
dans un état dans lequel ladite partie coulissante (3, 4) est disposée à ladite position saillante et ledit corps principal de montage (2) est monté directement sur ladite surface de montage (80), les deux côtés de ladite autre partie d'engagement coulissante (34, 44) dans une direction perpendiculaire à ladite surface de fond (21) sont en contact direct ou indirect avec ladite autre partie de verrouillage de position saillante (254, 264) et ladite surface de montage (80).
